# DEMANDE DE BREVET EUROPEEN

(11) **EP 2 722 795 A1**
(43) Date de publication de la demande: **23.04.2014**
(21) Numéro de dépôt: 12306300.0
(22) Date de dépôt: 19.10.2012
(51) Int. Cl.: G06K 19/077

(54) **Procédé de fabrication d'un dispositif multi-composants comprenant un module électrique et/ou électronique**

(71) Demandeur: Gemalto SA, 92190 Meudon (FR)
(72) Inventeur: Thill, Michel, 78340 Les Clayes Sous Bois (FR); Arnoux, Christophe, 13390 Auriol (FR)

(57) **Abrégé**

L'invention concerne un procédé pour la fabrication d'un dispositif électrique et/ou électronique multi-composants (100) comportant un module électrique et/ou électronique (7, 27) ledit procédé comprenant les étapes suivantes :
- réalisation d'un corps-support (31, 131, 231) comportant un premier (54a, A1, A4) et un second (54b, A2, A5) circuits électriques / électroniques et une zone de connexion (42) du module, chaque circuit ayant des plots de connexion (32, 132) s'étendant dans la zone de connexion (42) pour une connexion au module,
- réalisation du module comportant au moins un troisième circuit électrique / électronique (8, 134, A3),
- report du module dans / sur le corps-support pour connecter le troisième circuit ;

Le dispositif se distingue en ce que l'étape de connexion du troisième circuit (8, 134, A3) s'effectue à l'un seulement desdits premier (54a, A1, A4) et un second (54b, A2, A5) circuits.

L'invention concerne également un dispositif correspondant au procédé.

## Description

### Domaine de l'invention.

L'invention concerne un procédé de fabrication d'un dispositif multi composants comportant un corps-support recevant un module doté d'au moins un premier circuit électrique et/ou électronique et débouchant de préférence en surface du dispositif.

L'invention peut concerner notamment le domaine des supports électroniques tels que cartes à puce à contacts débouchant en surface, sans contact ou cartes hybrides, tickets ou étiquettes radiofréquences, transpondeurs radiofréquences, inserts (ou inlay) intégrant ou constituant un tel module.

Il concerne en particulier des dispositifs électroniques multi-composants notamment au format carte, jeton ou équivalent et comportant une antenne radiofréquence pour des transactions sans contact mettant en oeuvre des applications bancaires (EMV), d'identité, de sécurité, d'authentification, d'accès ... existant actuellement dans le monde des cartes à puces.

De tels dispositifs peuvent comporter des composants électroniques divers tels que par exemple un afficheur, un clavier, une batterie, etc. ; Ces dispositifs peuvent générer des fonctions telles que génération d'un numéro à usage unique (OTP), permettre d'afficher les dernières transactions bancaires effectuées, tout en associant des fonctions standard de type paiement, transport, identification...

De tels supports électroniques peuvent être conformes notamment au standard ISO / IEC 14443 ou ISO 78016.

Le terme circuit électrique signifie tout ou partie d'éléments conducteur de courant électrique notamment des plages de contacts électriques, des pistes conductrices, des connexions, des pistes de redirection, des plots électriques associés ou non à au moins un circuit intégré ou composant électronique / électrique (capacité, bobine, résistance...) connecté à ce circuit électrique. Le terme circuit électrique / électronique vise notamment des puces de circuit intégré telles que celles du domaine de la carte à puce, notamment puce à interface duale (contact et sans contact), diode électroluminescente, capteur audio, microcontrôleur, contrôleur de communication notamment de champ radiofréquence de proximité NFC (Near field communication)

### Art antérieur.

Le brevet US 5 598 032 décrit un procédé d'assemblage d'un module destiné à se connecter à une antenne noyée dans un corps-support de carte à puce hybride (contact et sans contact), il est connu de ménager une cavité dans le corps-support de manière à rendre les plages de connexion de l'antenne accessibles pour une connexion avec le module lors de son report dans la cavité. Des éléments d'interconnexion conducteurs de toute sorte peuvent relier des zones de connexion du module disposées en dehors de l'enrobage et les plages de connexion de l'antenne.

### Problème technique.

Actuellement, un circuit électrique / électronique notamment à antenne, est conçu avec des caractéristiques complémentaires à celles d'une puce d'un module associé pour obtenir le fonctionnement souhaité.

Comme les caractéristiques des puces changent selon les fournisseurs, il est nécessaire d'avoir autant de corps-supports, d'inserts ou de corps de carte à antenne différents qu'il existe de puces différentes pouvant être placées dans le module.

Un changement de puce (selon les fournisseurs) rend inutilisables tous les corps-supports multi-composants si la puce ou autre composant du module n'est pas compatible (caractéristiques, fonctionnalités) avec notamment une antenne ou autres composants prédéfinis à l'avance dans le dispositif multi-composants.

En particulier, il est nécessaire de prévoir autant d'antennes différentes (nombre de spires, capacité, diamètre du fil d'antenne, parcours, impédance, inductance...) qu'il y a de puces spécifiques différentes à connecter. Cela présente l'inconvénient d'avoir à stocker plusieurs types différents de corps-support à antenne ; A cela s'ajoute la complexité de conception et fabrication de plusieurs corps-supports à antenne différents.

Le problème est accentué par la complexité croissante des corps-supports ou inserts lorsqu'ils sont de type multi-composants ou ont des fonctionnalités différentes (même sans antenne). En effet, ces corps-supports multi-composants envisagés sont susceptibles de recevoir (en plus de l'antenne), des modules intégrant une puce notamment à interface duale (contact et sans contact) d'autres composants, par exemple un écran, nécessitant d'être connectées électriquement à un circuit contenu dans la carte, une batterie, un capteur d'empreinte, un clavier, un bouton, etc.

### Résumé de l'invention.

L'invention consiste à réaliser selon un mode préféré, un corps-support multi-composants générique permettant de recevoir plusieurs types de modules du fait notamment de l'utilisation de puces électroniques spécifiques différentes ou de circuits internes différents dans le module.

L'invention prévoit selon un mode de réalisation, de réaliser un corps-support générique pouvant être compatible avec au moins deux types de modules ; l'invention peut prévoir à cet effet au moins deux circuits optionnels ou complémentaires dans le corps support à connecter selon le type de module envisagé. Les circuits optionnels peuvent être utilisables ou activables en fonction des types de puce / module disponibles.

En particulier, selon un mode de mise en oeuvre, le support peut être au format carte comportant au moins deux antennes dont les extrémités de connexion sont à connecter à un module. Le module peut être encarté dans le corps ou posé sur le corps.

Selon un mode opératoire possible du procédé, lors du report de la puce sur le module et connexion de la puce à des plages d'interconnexion du module, on sélectionne un jeu de plages / plots de connexion adéquat parmi au moins deux jeux de plages / plots disponibles sur le module, le jeu de plages / plots adéquat étant destiné à connecter les extrémités de connexion d'un circuit, notamment une antenne, compatible avec le circuit du module.

Selon un autre mode de mise en oeuvre, le corps support comporte au moins une spire d'une première antenne passant par un plot / plage de connexion du corps-support dans une zone de connexion avec le module, avant de s'étendre sur une portion significative de spire d'une seconde antenne ou au moins une spire finissant son parcours par un plot de connexion dans la zone de connexion.

De préférence, les deux circuits sont de même nature ou type, tels que antenne radiofréquence, capacité, résistance ou tout composant, à connecter avec le module pour offrir notamment différentes options de connexion ou d'assemblage. L'invention peut aussi prévoir dans le corps support, des circuits de nature différente entre eux, optionnels, alternatifs ou complémentaires, selon les caractéristiques des circuits disponibles pour le module.

Selon une caractéristique préférée de l'invention, le procédé pour la fabrication d'un dispositif électrique et/ou électronique, est conforme à la revendication 1.

Selon un mode de réalisation, le corps-support comporte un composant électronique, par exemple un micro contrôleur avec deux entrées optionnelles à connecter avec le module. Chaque entrée du composant conduit en interne à un circuit différent optionnel / alternatif selon notamment le circuit du module.

Selon un autre mode de réalisation différent ou complémentaire aux autres, le module et le corps-support peuvent comporter chacun, un composant optionnel de même nature tel qu'une antenne, un circuit intégré, une capacité, un capteur d'empreinte, etc.

Dans un cas de figure, une antenne optionnelle du module est une antenne reliée à une puce de circuit intégré radiofréquence située de préférence dans le module mais qui peut être alternativement dans le corps support. Une antenne optionnelle du corps-support peut, quant à elle, être de préférence une antenne relais / passive pouvant être connectée à une capacité d'accord en fréquence ; cette capacité peut être sous forme de composant intégré disposé soit sur le module, soit sur le corps support. Toute capacité CA peut être alternativement réalisée sous forme de plaques de condensateur sur le module ou le corps support.

Avec l'option de l'antenne passive, l'invention permet notamment de fournir une fonctionnalité de communication radiofréquence minimale grâce, d'une part, à un module embarquant au moins une antenne de format réduit, d'autre part, de fournir un dispositif plus performant / efficace en rendant l'antenne passive optionnelle du corps support opérationnelle pour amplifier la communication radiofréquence.

Ceci peut être réalisé en agençant et connectant une capacité de manière à ce qu'elle se connecte à l'antenne passive optionnelle du corps support par l'intermédiaire de ses plots de connexion, lors du report du module dans le corps support. La capacité peut être notamment sous forme de puce intégrée dans le module ou dans le corps support.

Le module peut également servir de moyen de renvoi et de redirection de circuits optionnels du corps-support, l'option étant choisie au niveau de l'assemblage du module ou lors du report de ce dernier (en plaçant des éléments de connexion / interconnexion (module / corps support) aux endroits appropriés pour choisir la bonne option.

L'invention a également pour objet un dispositif correspondant au procédé constituant ou comportant le module.

L'objet peut constituer de préférence une carte à plusieurs composants intégrant l'un des composants tels que : un afficheur avec ou sans son circuit de pilotage, un capteur d'empreinte digitale, un capteur d'une autre grandeur physique (rayonnement, température, analyse chimique...), une source d'énergie (cellule solaire, élément de collecte d'énergie, batterie primaire ou rechargeable...),

Le facteur de forme de la carte peut être celui d'une carte IDO, Plug-in UICC, d'un passeport électronique, d'un ticket notamment d'épaisseur inférieure à 0.8 mm.

Brève description des figures.
- Les figures 1 et 2 illustrent un module de carte à puce de l'art antérieur modifié conformément à un premier mode de mise en oeuvre du procédé de l'invention respectivement en vue de dessus et en coupe ;
- La figure 3 illustre un module de carte à puce obtenu conformément à un second mode de mise en oeuvre du procédé de l'invention ;
- La figure 4 illustre un corps-support compatible avec le second mode de mise en oeuvre du procédé de l'invention ;
- La figure 5 est une vue en coupe partielle d'un dispositif comportant le module conforme à l'invention, reçu dans une cavité d'un corps support comportant le circuit ou corps support 31 multi-composants de la figure 4 ;
- La figure 6 illustre une cavité dans un dispositif pouvant comprendre un des corps-supports multi-composants décrits précédemment ;
- La figure 7 illustre un corps-support conforme à un autre mode de mise en oeuvre du procédé de l'invention ;
- Les figures 8 et 9 illustrent une vue de dessus d'un module de carte à puce selon deux configurations optionnelles pouvant être associées notamment à l'un des corps supports des figures 4, 6 ou 7;
- La figure 10 illustre une vue de dessus d'un module de carte à puce selon un autre mode de réalisation, comportant plusieurs composants et pouvant être destiné à coopérer notamment avec le corps support à antenne de la figure 7 ;
- La figure 11 illustre une vue de dessus d'un corps support de carte à puce selon un autre mode de réalisation comportant un parcours d'antenne offrant deux options de connexion.

### Description.

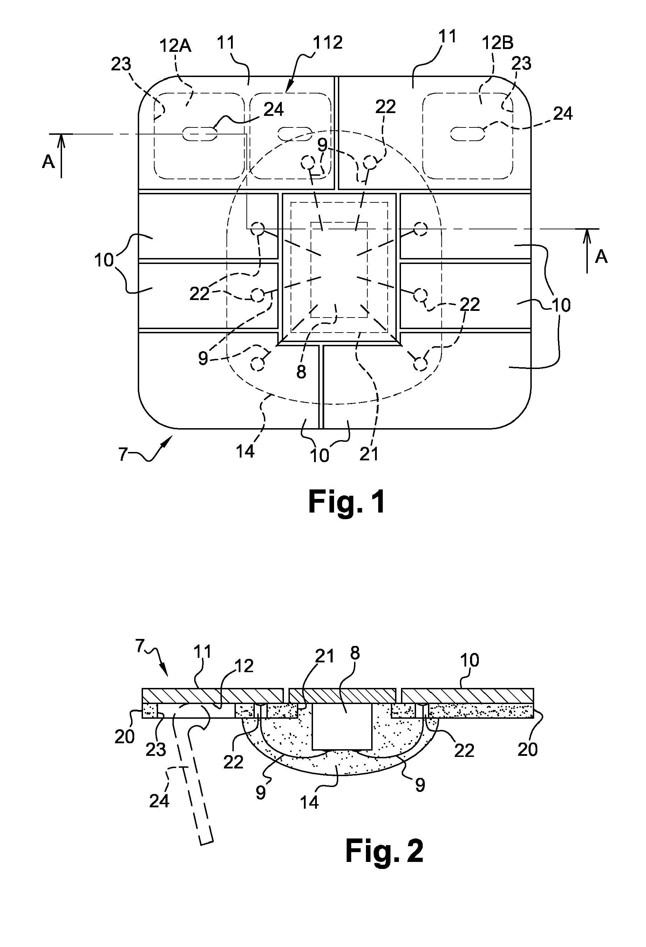

Le procédé pour la fabrication d'un dispositif électrique et/ou électronique multi-composants 100 comportant un module électrique et/ou électronique 7 va être décrit ci-après en référence avec les figures 1 et 2.

Le procédé prévoit d'une part la réalisation d'un corps support 31 (décrit ultérieurement et comportant un premier circuit électrique / électronique avec une zone 42 de report et de connexion du module) ; d'autre part, il prévoit la réalisation du module 27 (décrit ci-après) comportant au moins un second circuit électrique /électronique.

Les figures 1 et 2 illustrent un exemple de module 7 de carte à puce de circuit intégré hybride de l'art antérieur qui a été adapté selon les enseignements de l'invention.

Le module 7 comprend des plages de contact 10, 11 sur un support 20 diélectrique ou isolant notamment du type LFCC (Lead frame contrecollé), au moins une puce de circuit intégré 8 reportée sur le support 20 ou ici sur une plage métallique de contact ou non. Les plages de contact sont destinées à connecter un connecteur de lecteur de carte à puce.

Le module comprend également des connexions 9 pour notamment connecter des plages de contact par fils soudés, par colle conductrice ou autre, une puce électronique 8 (ici de type hybride) pouvant être retournée (flip-chip) ou non ; Il comprend un enrobage 14 de la puce et/ou de ses connexions par une matière de protection telle une résine (glob-top).

Les connexions 9 peuvent connecter les plages de contact à travers des orifices 22 ménagés dans le support isolant.

La surface inférieure du module s'étendant sensiblement du bord de l'enrobage jusqu'au bord du module pour constituer une surface de collage du module sur un plan d'une cavité ménagée dans le corps de carte.

Le module comprend également des moyens de connexion 24 (languettes, ressort, etc.) pour connecter un circuit tel une antenne ou autre composant noyé dans un corps de carte recevant le module. Ces moyens 24 peuvent connecter deux plages conductrices 12A, 12B du module à travers deux orifices 23 situés dans la surface de collage du module sur le corps de carte ou du moins en dehors de la matière de protection 14. Ces deux plages 11 sont connectées aux plots radiofréquences de la puce, ici par fils soudés à travers des orifices 23 (ou similaire 22).

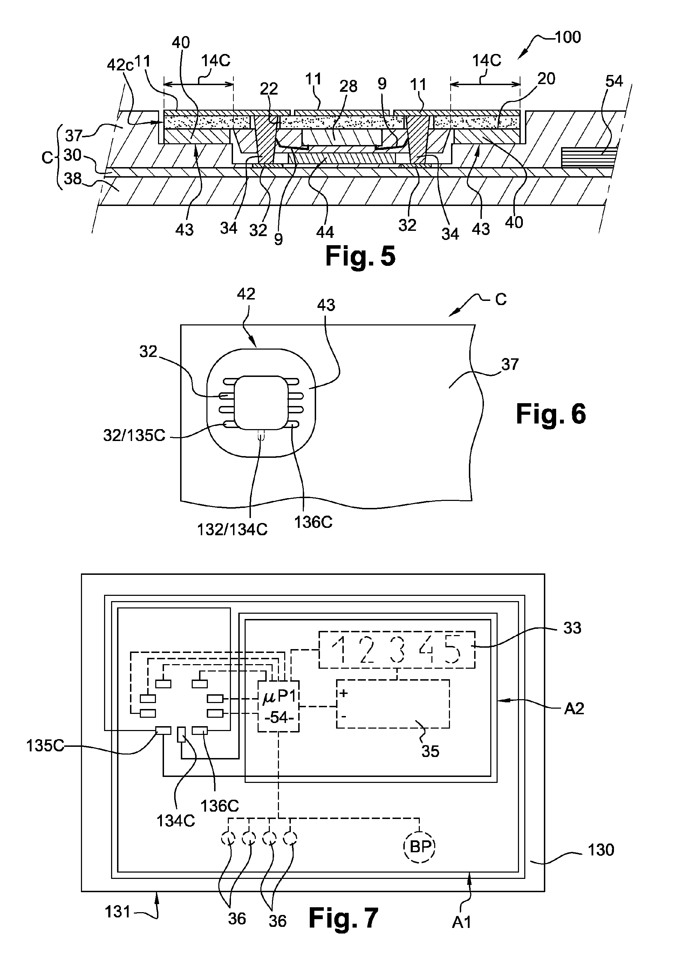

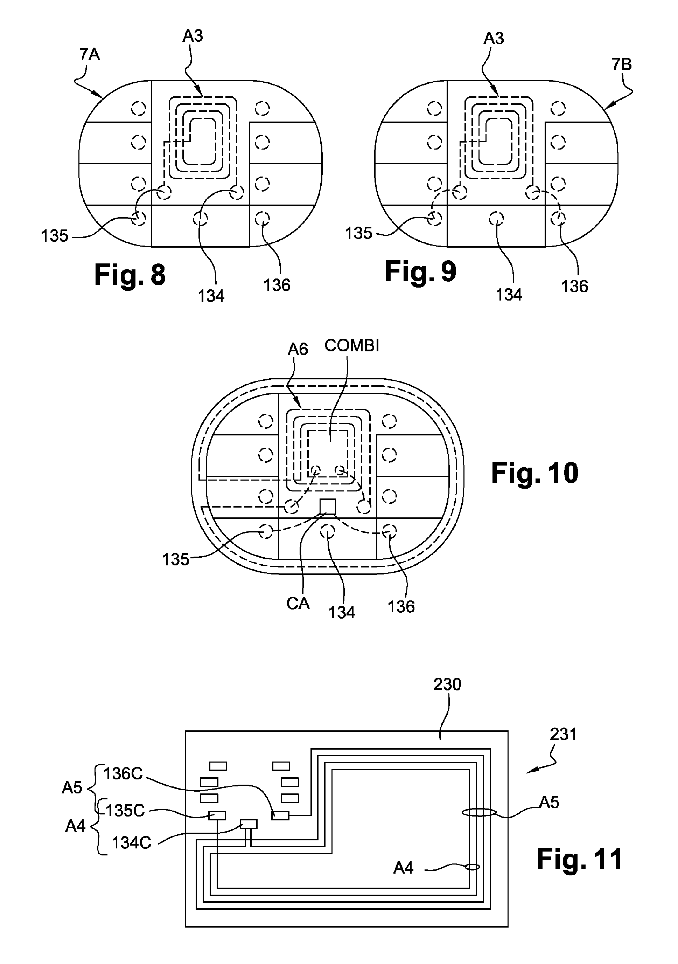

Selon une adaptation de ce module pour satisfaire un premier mode de réalisation de l'invention, le module susvisé peut prévoir au moins trois plots d'interconnexion / interconnexion (ou emplacements d'interconnexion avec un circuit du corps support) 12A, 12B, 112 pour connecter deux plots de connexion d'une antenne (ou autre élément électrique / électronique) disposé dans un corps-support. Le plot ou emplacement de connexion ici 12A étant optionnel n'est pas utilisé car son emplacement d'interconnexion correspond à une antenne du corps-support (par exemple A1) qui n'est pas compatible ou non sélectionnée volontairement. Par contre, une autre antenne A2 du corps-support peut être interconnectée à la puce 8 par l'intermédiaire des plages / plots d'interconnexion 112, 12B et bornes 134C, 135C visibles notamment dans la figure 7 voire à la figure 11 pour une autre portion d'antenne.

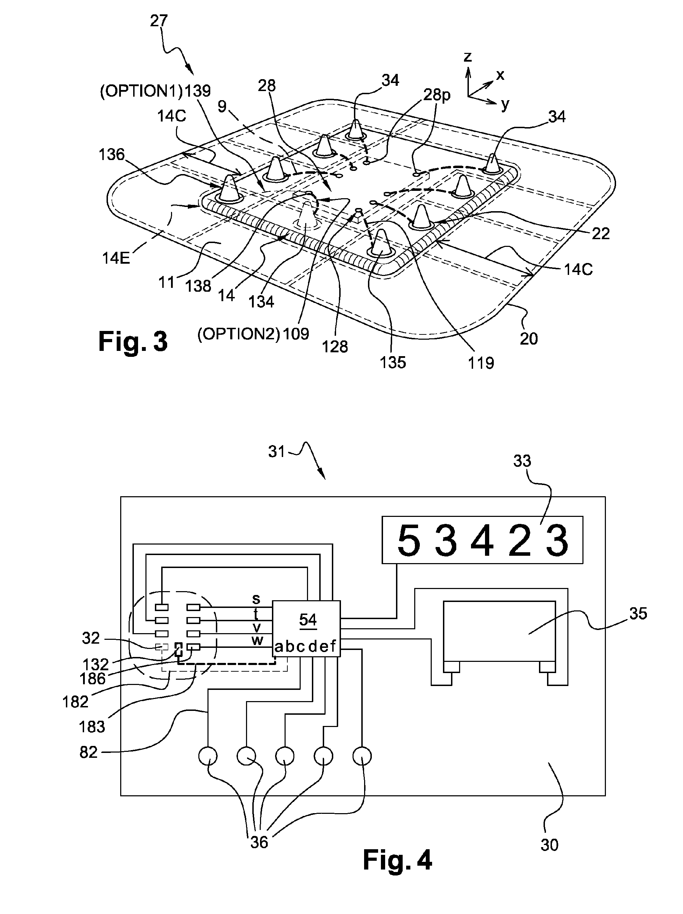

La figure 3 illustre un exemple d'un second mode de réalisation de module 27 de carte à puce 28 multi-composants électronique pouvant être utilisé après adaptation selon l'invention. Ce module correspond à un mode préféré de réalisation car beaucoup plus sophistiqué pour une meilleure compréhension de l'intérêt/avantage de l'invention.

Les mêmes références d'une figure à l'autre indiquent des moyens identiques ou similaires. Ce module 27 peut différer principalement du précédent 7 en ce qu'il prévoit plusieurs plots 34 (similaire à 24) faisant saillie hors de la résine d'enrobage 14 pour une connexion / interconnexion avec un corps support.

Ce module 27 comprend une puce 28 avec des plots ou bornes 28P reliés à des plots / bornes / plages 34 du module. Les plots peuvent relier ou non des plages de contacts 11 notamment selon que l'on souhaite ou non une interaction de la puce du module avec un lecteur à contact.

Selon une adaptation pour l'invention, le procédé prévoit d'ajouter au moins un plot 134 optionnel/ alternatif (en pointillé) par rapport aux autres plots. Il est ici sur une plage de contact 11 séparé des autres plages de contact qui portent d'autres plots 34 ou emplacement pour une connexion avec un circuit du corps-support.

La liaison de connexion 109 du plot 128 de puce 28 au plot 134 du module (en pointillé) représente une option ou alternative de connexion que propose l'invention par rapport à la liaison de connexion 139 du plot 138 de puce au plot 136 du module.

Le module 27 à puce à circuit intégré ou électronique 28, peut être sensiblement du même type que sur la figure précédente ; Il comprend un substrat 20 et une matière de protection 14 enrobant au moins partiellement le circuit électronique 28 dans une zone d'enrobage 14E.

La zone d'enrobage est entourée par une surface périphérique 14C de fixation du module ou de collage. Cette surface périphérique 14C est de préférence d'une largeur sensiblement constante autour de l'enrobage et est destinée à adhérer à un corps-support décrit ultérieurement soit directement soit via un moyen de fixation tel un adhésif.

La puce électronique 28 peut connecter des plages de contact 11 à travers des orifices 22 par tout moyen connu et en l'occurrence par des fils soudés

En alternative, le module peut comporter ou non une puce 28, celle-ci pouvant être déportée ou substituée par un autre composant à enrober ; Le module peut comporter uniquement des plots / plages reliant des pistes ou des plages conductrices du module, par exemple pour une redirection ou activation de tout ou partie du circuit électronique d'un corps-support associé.

La puce 28 peut ou non réaliser des fonctions de communication avec un lecteur à contact. En fait, ces fonctions et/ou la puce peuvent être déportées dans un dispositif support tel un corps-support de carte ou autre. Le module peut comporter par exemple au moins une puce de capteur d'empreinte ou autre moyen d'authentification, de température, une diode réceptrice et/ou émettrice...

Le module peut être ou non noyé dans un corps-support ou corps contenant le circuit 32 (bornes) et/ou autre composants. (Cas d'un module sans plage de contact conforme à l'ISO 7816)

Selon l'exemple, des plots de connexion 34 du module font saillie de la surface d'enrobage vers l'extérieur du module. Ils s'étendent ici perpendiculairement (axe Z) par rapport au plan principal du module (X, Y).

A la figure 4 est illustrée une autre étape de réalisation d'un corps-support selon le second mode de mise en oeuvre portant, comportant ou constituant un circuit électronique 31 à plusieurs composants dans ou sur un substrat isolant 30 ; Le circuit 31 est conçu de manière à comprendre des plages / bornes de connexion 32 du circuit 31 regroupées dans une zone de report /connexion 42 du module de manière à le connecter.

Le circuit 31 peut comprendre plusieurs composants dans ou sur un corps-support (substrat). Le circuit 31 comprend ici par exemple un afficheur 33, un microcontrôleur 54, une batterie 35, des boutons ou clavier 36 et au moins des plages de connexion 32 reliant des composants du circuit par notamment des pistes d'interconnexion ou de liaison 82. Le cas échéant, le circuit peut être composé uniquement par des plages de connexion 32 ; celles-ci peuvent par exemple servir à effectuer une redirection d'un circuit électronique /électrique du corps support.

Le cas échéant, le corps-support / circuit 31 peut également comporter au moins une antenne radiofréquence (non illustrée) A1, A2 comme décrit ultérieurement à la figure 6.

Selon le second mode de mise en oeuvre, l'invention prévoit une intégration d'un second circuit électrique /électronique dans le corps support optionnel / alternatif par rapport à un premier circuit ; ce second circuit est matérialisé à la figure 4 par une plage / borne d'interconnexion 132 supplémentaire (en pointillé) reliée au composant 54 (entrée a) par une piste 183 ; Ce second circuit (132, 183, 54a) constitue une option ou alternative par rapport au premier circuit (32, 182, 54b) comportant la plage / borne 32 d'interconnexion reliant le composant 54 (par l'entrée b) via la piste 182. Ici, seul le second circuit (132, 183, 54a) est branché, le premier circuit alternatif (32, 182, 54b) étant laissé non connecté comme expliqué ultérieurement.

Grâce notamment de telles dispositions ci-dessus, selon une caractéristique, le procédé de l'invention comprend une étape de connexion d'un troisième circuit du module au choix parmi un premier et un second circuits du corps-support. Le choix se produit notamment selon la nature du troisième circuit du module ou selon des fonctionnalités choisies délibérément.

Dans cet exemple, la puce de circuit intégré 28 comprend une fonctionnalité évoluée (par exemple sécurisation /authentification réciproque / niveau de potentiel stabilisé) que supporte le composant 54 sur son entrée a) contrairement à son entrée b).

Dans ce cas, le procédé de l'invention permet de choisir et brancher une puce 28 évoluée sur le plot central 134 du module (figure 3) correspondant au second circuit évolué 54a) et à la borne / plage 132 du corps support, au lieu de la borne / plage latérale 136 (laissée non connectée).

Le recours à cette dernière borne / plage 136 permettrait un branchement de la puce 28 à l'entrée b) du composant 54 pour former un premier circuit ordinaire (par exemple sans sécurisation / authentification réciproque / autre niveau de potentiel / non stabilisé).

Alternativement, il peut ne pas y avoir de choix entre une puce évoluée et une puce moins évoluée parce qu'on dispose d'une seule puce standard mais on préfère activer ou non des fonctionnalités en fonction d'options déterminées par un client. Pour des raisons de rationalisation, le corps support peut comprendre d'office toutes les fonctionnalités permises par une puce donnée et on peut alors sélectionner celles choisies par un client au dernier moment au niveau de l'encartage et personnalisation.

A la figure 5, l'invention prévoit selon une caractéristique, une étape de report du module 27 dans /sur le corps-support (C /30 /31) multi-composants pour le connecter. Cette figure peut illustrer les connexions entre module et corps support des figures 3, 4, 6, 7. Le module est ici encarté dans un corps-support C comportant au moins des plages de connexion 32 du circuit 31 pour le connecter.

Des plots ou excroissances 34, 134 du module connectent directement des plages de connexion 32, 132 du corps-support notamment les plages de connexion du circuit 31.

Le corps-support 31 peut être un corps de carte à puce comportant le substrat 30 ou un dispositif similaire. Le module est reporté de préférence dans une cavité 42C (correspond à la zone de report / connexion 42) avec plan de fixation 43 du corps-support. Le corps-support C à la figure 5 comprend une couche isolante supérieure 37 et inférieure 38 par rapport au circuit 31.

Le module reporté est fixé ici par un adhésif 40 du type thermo-adhésif (hotmelt). Le cas échéant, on peut ajouter un point de colle ou adhésif 44 au fond de la cavité pour adhérer à l'enrobage 14.

A la figure 6 est illustrée une vue partielle d'un corps support multi-composants 31 (fig. 4) ou 131 (fig. 7), revêtu de couches inférieure 36 et supérieure 37. Il comprend les plages de connexion 32, 132 du circuit 31 de la figure 4 ou les plages de connexion 134C, 135C et 136C du circuit multi-composants électrique / électronique 131 (ou corps support) de la figure 7. La cavité 42C faite notamment par usinage permet de révéler ou rendre accessible des plages de connexion 32 du corps support, du moins celles nécessaire à l'option ou alternative choisie

Selon une caractéristique possible du procédé de l'invention, on peut prévoir d'effectuer l'étape de connexion du module au circuit du corps support au cours de l'étape de fixation du module sur une surface 43 du corps support C.

A la figure 7, on a représenté un autre mode de réalisation du corps-support 131 comportant au moins deux circuits électriques / électroniques. Les mêmes composants du corps support de la figure 4 notamment afficheur 33, batterie 35, microcontrôleur 54, clavier 36, bouton pression BP... sont illustrés en pointillés car facultatifs pour ce mode de réalisation de l'invention mais préférés pour la compréhension.

Ces circuits A1, A2 sont ici de nature identique : il s'agit ici de deux antennes radiofréquences de portée différente ou requérant un accord de fréquence différent en relation avec une puce radiofréquence (L'invention prévoit aussi en variante que les circuits peuvent être de nature différente). Chaque antenne comporte des extrémités de connexion respectivement 135C, 136C pour l'antenne A1 et 135C, 134C pour l'antenne A2, un plot d'interconnexion 135C étant de préférence (mais sans obligation) commun aux deux antennes.

Un module similaire notamment de la figure 3 ou 10 peut être reporté sur ou dans le corps-support 131 ; La puce radiofréquence peut être connectée à l'une ou l'autre antenne selon ses caractéristiques comme par exemple, la valeur de la capacité interne à la puce, les critères de portée / performances requis pour la communication, l'accord de fréquence qu'elle est en mesure d'apporter en association avec une antenne.

Dans l'exemple, la puce disponible requiert une inductance plus importante correspondant à l'antenne A1 pour permettre un fonctionnement correct.

Dans ce cas, grâce à l'invention, il est plus aisé d'adapter le module en fonction des puces disponibles dans la mesure où les corps-supports sont figés et enrobés en étant agencés de manière optimisée ; Ils peuvent être optimisés du moins en ce qui concerne la forme et emplacement des spires d'antenne, tenant compte notamment des interférences / perturbations radiofréquences des autres composants (batterie, afficheur, surface métallique conductrice des pistes et boutons).

Si on choisit de connecter l'antenne A1, à la préparation du module (fig. 3), le corps support est déjà réalisé par ailleurs, le procédé de l'invention prévoit de choisir les plots de connexion 135, 136 du module (OPTION 1) pour connecter les plots radiofréquences (128, 138) de la puce avec ici des fils de liaison 119, 139. Cette opération s'effectue de manière transparente au cours de la connexion de la puce à chaque plot / plage de connexion du module. Dans ce cas, le plot 134 n'est alors pas connecté à la puce.

Inversement pour choisir l'antenne A2 via l'OPTION 2, on câble les plots radiofréquences de la puce aux plots alternatifs de connexion 134, 135 du module. Le plot 136 du module et plage correspondante 136C du corps-support restent non connectés et l'antenne A1 est désactivée.

Dans une version plus élémentaire, le module peut être celui de la figure 1 et l'on connecte la puce de la même manière sur les mêmes plots /plages d'interconnexion du module quelle que soit l'option. La sélection de l'antenne A1 (et option 1) s'effectue différemment, en disposant un élément de connexion 34 (ressort, languette ou autre), en regard de la borne / plage terminale (136C) de l'antenne A1 et l'emplacement 23 du module. La borne 135C étant ici dans l'exemple toujours connectée.

On remarque ici selon ce mode de réalisation que la plage centrale (134C) de l'antenne A2 (en tant que second circuit du corps support non sélectionné) demeure non connectée à l'emplacement de connexion supplémentaire 112 prévu par rapport aux deux emplacements normaux d'interconnexion 23 de l'art antérieur. Cela peut se faire, par exemple, pour des raisons de puce compatible ou pour utiliser un emplacement de l'antenne A1 dans la partie basse de la carte pour un embossage du type carte bancaire.

Inversement, on peut sélectionner l'antenne A2 en plaçant l'élément 34 précédent en regard de la borne / plage 112 du module pour connecter la plage 134C. La borne 136 n'est plus sélectionnée et donc A1 n'est plus activée.

Les figures 8 et 9 illustrent schématiquement un mode de réalisation d'un module sans puce (celle-ci pouvant être déportée dans le corps support ou absente selon ce mode). Le module comporte une antenne A3 de construction réduite comprise dans la surface du module. Elle est ici comprise au moins au centre du module. Ses extrémités terminales de connexion peuvent être branchées soit aux plots 135, 134 à la figure 8 soit aux plots 135, 136 à la figure 9 selon des options de communication choisies expliquées ci-après.

Cette antenne A3 peut venir connecter un composant 54 à une entrée a ou b (qui peut être fonctionnellement différente de celle présentée à la figure 4). Le composant 54 peut notamment comprendre dans ce cas une fonctionnalité radiofréquence pouvant avoir deux types de caractéristiques différentes selon le plot choisi (protocole, fréquence, capacité...).

Le composant 54 a ici pour l'exemple de module des figures 8 et 9, des entrées a et b permettant des fonctions sensiblement différentes de la figure 4. Les entrées 54a et 54b sélectionnent ici une capacité de forte valeur. Les entrées 54b et 54w sélectionnent ici une capacité de valeur plus faible que la précédente.

Selon un autre mode de réalisation non représenté, le module peut comprendre des plages de contact externes compatibles ISO 7816 et/ou plages conforme au standard USB. Le corps support peut comprendre un microcontrôleur ou deux assurant les deux protocoles de communication. Selon que la carte est destinée à l'un ou l'autre protocole selon les lecteurs disponibles, ce mode permet de connecter ou non les plots du module correspondant à l'un ou l'autre circuit ISO ou USB du corps de carte. Le module peut être ici aussi exempt de puce de circuit intégré.

A la figure 10, un autre mode de réalisation, le module 7C comporte une puce (COMBI) de type hybride à interface duale contact et radiofréquence, une capacité CA sous forme de puce intégrée. La puce hybride COMBI est connectée à des plots de plages de contact C1, C2, C3 C5, C6, C7 pour une communication selon l'ISO 7816 et à une antenne A6 comportant des spires sur la surface du module notamment au centre et/ou en périphérie du module. Le module est destiné à être encarté par exemple dans un corps-support 131 comportant au moins deux antennes conformément à la figure 7.

Selon une option possible, le module radiofréquence 7C avec l'antenne A6, est suffisamment performant à lui seul et il n'est pas utile d'activer la capacité CA avec une antenne relais / passive.

Dans le cas contraire, l'invention permet de recourir à cette antenne relais constituée de la capacité CA et l'une des deux antennes A1, A2 du corps support pour améliorer les performances de communication radifofréquence. Dans l'exemple, la capacité CA étant branchée sur le plot commun latéral 135 et plot latéral 136 du module, c'est l'antenne relais (A1 + CA) qui constitue l'antenne relais par connexion de ces derniers plots aux plages correspondantes 135C et 136C en regard.

Inversement, pour constituer l'antenne relais (A2 + CA), on branche la capacité sur les bornes 134 et 135 du module pour interconnecter ensuite les bornes 134C, 135C de l'antenne A2.

A la figure 11, une autre variante de réalisation du corps-support 230 comprend des spires d'antenne dont au moins trois points espacées (ici 134C, 135C, 136C) sont reliés respectivement à un plot de connexion du corps support. Grâce à cette disposition, on peut définir une première antenne A4 comprenant quelques spires entre les plages / bornes 135C et 134C et une seconde antenne A5 comprenant toutes les spires dont les extrémités sont branchées aux plages / bornes 135C, 136C.

Ainsi, on peut former au moins deux antennes ci-après ; une première antenne à spires réduites A4 et une seconde antenne A5 plus grande comportant lesdites spires réduites prolongées d'au moins une portion significative de spire à partir d'un des plots 134C et ayant des caractéristiques différentes compatibles avec une puce radiofréquence différente.

Selon les caractéristiques des puces disponibles, le procédé de l'invention permet de choisir l'antenne A4 ou A5 en connectant les plots 128, 138 de la puce 28 (fig.3) soit sur les plots correspondant de l'antenne A4 ou ceux de l'antenne A5 ci-dessus.

L'invention peut prévoir des options multiples de configuration dans chacun des objets à interconnecter (le circuit électrique / électronique du module et/ou le circuit électrique / électronique du support). Avant ou lors de la connexion du module, on peut configurer les objets à interconnecter, au moins celui qui est le plus facile (moins couteux) à modifier selon l'option choisie et ceci à une phase quasi ultime de réalisation du dispositif résultant (notamment après réalisation du corps-support selon l'exemple préféré)

## Revendications

1. Procédé pour la fabrication d'un dispositif électrique et/ou électronique multi-composants (100) comportant un module électrique et/ou électronique (7, 27) ledit procédé comprenant les étapes suivantes :
- réalisation d'un corps-support (31, 131, 231) comportant un premier (54a, A1, A4) et un second (54b, A2, A5) circuits électriques / électroniques et une zone de connexion (42) du module, chaque circuit ayant des plots de connexion (32, 132) s'étendant dans la zone de connexion (42) pour une connexion au module,
- réalisation du module comportant au moins un troisième circuit électrique / électronique (8, 134, A3),
- report du module dans / sur le corps-support pour connecter le troisième circuit,
**caractérisé en ce que** l'étape de connexion du troisième circuit (8, 134, A3) s'effectue à l'un seulement desdits premier (54a, A1, A4) et un second (54b, A2, A5) circuits.

2. Procédé selon la revendication précédente, **caractérisé en ce que** premier et second circuits sont utilisables ou activables en fonction du type du troisième circuit.

3. Procédé selon l' une des revendications précédentes, **caractérisé en ce que** premier et second circuits sont de même nature tels que deux antennes radiofréquences (A1, A2), capacités, résistances, composants de circuit intégré, capteurs d'empreinte.

4. Procédé selon l'une des revendications précédentes, **caractérisé en ce que** le corps-support comporte un composant (54) avec deux entrées optionnelles (54a, 54b) conduisant à / formant deux circuits internes dans le composant.

5. Procédé selon la revendication 3, **caractérisé en ce que** le corps-support comprend une antenne relais /passive (A1, A2) pouvant être connectée à une capacité (CA) d'accord en fréquence, cette dernière étant disposée notamment dans le module.

6. Procédé selon l'une des revendications précédentes, **caractérisé en ce que** le troisième circuit comprend des moyens de renvoi / redirection (132, 134, 134C) desdits premier et second circuits.

7. Procédé selon la revendication précédente 3, **caractérisé en ce qu'**au moins une spire d'une antenne (A4) passe par un plot / plage de connexion (134C) du corps-support (231) avant de s'étendre sur une portion significative de spire d'antenne (A5) ou au moins une spire pour former une seconde antenne A5.

8. Procédé selon l'une quelconque des revendications précédentes, selon lequel :
- ledit corps-support (C, 31, 131, 231) a la forme d'un corps de carte,
- lesdits premier et second circuits sont réalisés de manière à avoir leurs plots de connexion (32, 132) s'étendant dans une zone de connexion (42) du module,
- au moins une cavité (42C) est ménagée dans le corps de carte de manière à révéler ou rendre accessible au moins les bornes du premier et/ou du second circuit à connecter,
- le module (7, 27) est reporté et fixé dans / sur ladite cavité, l'un des premier (54a, A1, A4) et un second (54b, A2, A5) circuits connectant lesdites bornes du troisième circuit.

9. Dispositif électrique et/ou électronique multi-composants comportant un module électrique et/ou électronique (7, 27), comprenant :
- un corps-support (31, 131, 231) comportant un premier (54a, A1, A4) et un second (54b, A2, A5) circuits électriques / électroniques et une zone de connexion (42) du module, chaque circuit ayant des plots de connexion (32, 132) s'étendant dans la zone de connexion pour une connexion au module,
- un module comportant au moins un troisième circuit électrique / électronique (8, A3), ledit module étant reporté dans / sur le corps-support,
**caractérisé en ce que** le troisième circuit (8, A3) est connecté à l'un seulement desdits premier (54a, A1, A4) et un second (54b, A2, A5) circuits.
